# DEMANDE DE BREVET EUROPEEN

(11) **EP 0 543 697 A1**
(43) Date de publication de la demande: **26.05.1993**
(21) Numéro de dépôt: 92403010.9
(22) Date de dépôt: 06.11.1992
(51) Int. Cl.: H03K 17/687, H03K 17/08

(54) **Interrupteur de puissance à commutateur MOS**

(30) Priorité: 13.11.1991 FR 9113936
(71) Demandeur: NOKIA CONSUMER ELECTRONICS FRANCE S.A., F-93230 Romainville (FR)
(72) Inventeur: Moreau, Michel, F-93000 Montreuil sous Bois (FR)
(74) Mandataire: Habasque, Etienne Joel Jean-François

(57) **Abrégé**

Cet interrupteur de puissance à commutateur MOS (4) interposé entre une source de tension d'alimentation (+ V) et une charge, et dont la grille est reliée à des moyens de commande (5) pilotés par un signal de commande (C), est caractérisé en ce que le commutateur MOS (4) est un commutateur à canal N, dont le drain est relié à la source de tension d'alimentation et dont la source est reliée à la charge à travers une diode de blocage (6), en ce que la grille du commutateur est portée au moins à la tension d'alimentation (+ V) et en ce qu'un limiteur de tension (8) est connecté entre la source et la grille du commutateur (4) pour limiter la différence de potentiel entre grille et source lors de la conduction du commutateur et limiter la tension inverse entre grille et source lors du blocage de celui-ci.

## Description

La présente invention concerne un interrupteur de puissance à commutateur MOS.

On connait déjà dans l'état de la technique un certain nombre d'interrupteurs de ce type dans lesquels un commutateur MOS est interposé entre une source de tension d'alimentation et une charge et dont la grille est reliée à des moyens de commande pilotés par un signal de commande.

Les commutateurs MOS utilisés dans ces applications sont des commutateurs MOS à canal P.

Cependant ces commutateurs MOS à canal P présentent un certain nombre d'inconvénients notamment au niveau de leur contrainte de spécification maximale de tension et de leur prix de revient.

Il est bien entendu possible d'utiliser des transistors de puissance pour réaliser ces interrupteurs mais le prix de revient de ces,transistors est également élevé.

Le but de l'invention est donc de résoudre ces problèmes en proposant un interrupteur utilisant un commutateur de technologie MOS dont le prix de revient soit réduit par rapport aux interrupteurs de l'état de la technique et qui puisse supporter une tension supérieure.

A cet effet l'invention a pour objet un interrupteur de puissance à commutateur MOS interposé entre une source de tension d'alimentation et une charge et dont la grille est reliée à des moyens de commande pilotés par un signal de commande, caractérisé en ce que le commutateur MOS est un commutateur à canal N, dont le drain est relié à la source de tension d'alimentation et dont la source est reliée à la charge à travers une diode de blocage, en ce que la grille du commutateur est portée au moins à la tension d'alimentation et en ce qu'un limiteur de tension est connecté entre la source et la grille du commutateur pour limiter la différence de potentiel entre grille et source lors de la conduction du commutateur et limiter la tension inverse entre grille et source lors du blocage de celui-ci.

L'invention sera mieux comprise à l'aide de la description qui va suivre donnée uniquement à titre d'exemple et faite en se référant aux dessins annexés sur lesquels :
- La figure 1 représente un schéma électrique d'un interrupteur de l'état de la technique ; et
- La figure 2 représente un schéma électrique d'un interrupteur selon l'invention.

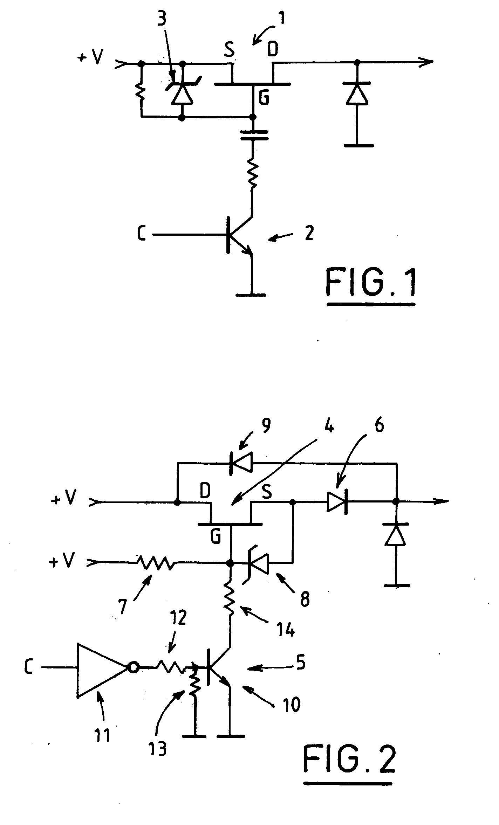

Ainsi qu'on peut le voir sur la figure 1, un interrupteur de puissance de l'état de la technique comporte un commutateur MOS à canal P désigné par la référence générale 1 sur cette figure, interposé entre une source de tension d'alimentation + V et une charge (non représentée).

La source de ce commutateur MOS est reliée à la source de tension d'alimentation tandis que son drain est relié à la charge. La grille de celui-ci est reliée à des moyens de commande désignés par la référence générale 2 et comprenant par exemple un transistor piloté par un signal de commande C appliqué sur la base de celui-ci.

Une diode Zener 3 est connectée entre la source et la grille de ce commutateur MOS.

Ainsi qu'on l'a évoqué précédemment l'utilisation des commutateurs MOS à canal P présente un certain nombre d'inconvénients.

Sur la figure 2, on a représenté un interrupteur de puissance selon l'invention.

Celui-ci comporte également un commutateur MOS, 4, interposé entre la source de tension d'alimentation + V et la charge. La grille de ce commutateur est également reliée à des moyens de commande 5 pilotés par le signal de commande C.

Dans l'interrupteur de puissance selon l'invention, le commutateur MOS est un commutateur à canal N dont le drain est relié à la source de tension d'alimentation et dont la source est reliée à la charge à travers une diode de blocage 6. La grille du commutateur est portée au moins à la tension d'alimentation + V en étant reliée par exemple à la source d'alimentation, à travers une résistance 7.

Par ailleurs, un limiteur de tension tel qu'une diode Zener, 8, est également connecté entre la source et la grille de ce commutateur pour limiter la différence de potentiel entre grille et source lors de la conduction du commutateur et limiter la tension inverse entre grille et source lors du blocage de celui-ci.

Une diode de roue libre 9 est également connectée entre la source et le drain du commutateur.

Par ailleurs, les moyens de commande désignés par la référence générale 5 sur cette figure, comprennent un transistor à collecteur ouvert 10 relié à la grille du commutateur MOS et dont l'émetteur est relié au zéro de référence commun entre la source de tension d'alimentation et la charge. La base de ce transistor est attaquée par la sortie d'un inverseur 11 recevant en entrée le signal de commande C.

Bien entendu, des résistances de polarisation 12, 13 et 14 sont utilisées pour assurer la polarisation des différentes bornes de ce transistor.

On conçoit donc qu'en fonction de l'état du signal de commande C présent à l'entrée de l'inverseur 11, le transistor 10 est passant ou non passant, ce qui permet de bloquer ou de débloquer le commutateur MOS à canal N, 4, pour alimenter ou non la charge connectée à la source de celui-ci.

L'utilisation de ces commutateurs à canal N permet de réduire les coûts de fabrication de ces interrupteurs car leur prix de revient est beaucoup moins élevé que celui des commutateurs à canal P et de commuter une tension plus élevée dans la mesure où ceux-ci supportent des tensions plus élevées.

En particulier, ces interrupteurs peuvent être utilisés dans des alimentations à haute tension pour le balayage horizontal par exemple d'un récepteur de télévision.

## Revendications

1. Interrupteur de puissance à commutateur MOS (4) interposé entre une source de tension d'alimentation (+ V) et une charge, et dont la grille est reliée à des moyens de commande (5) pilotés par un signal de commande (C), caractérisé en ce que le commutateur MOS (4) est un commutateur à canal N, dont le drain est relié à la source de tension d'alimentation et dont la source est reliée à la charge à travers une diode de blocage (6), en ce que la grille du commutateur est portée au moins à la tension d'alimentation (+ V) et en ce qu'un limiteur de tension (8) est connecté entre la source et la grille du commutateur (4) pour limiter la différence de potentiel entre grille et source lors de la conduction du commutateur et limiter la tension inverse entre grille et source lors du blocage de celui-ci.

2. Interrupteur de puissance selon la revendication 1, caractérisé en ce qu'une diode de roue libre (9) est connectée entre la source et le drain du commutateur (4).

3. Interrupteur de puissance selon la revendication 1 ou 2, caractérisé en ce que les moyens de commande (5) comprennent un transistor à collecteur ouvert (10) relié à la grille du commutateur, dont l'émetteur est relié au zéro de référence commun entre la source de tension d'alimentation et la charge et dont la base est attaquée par la sortie d'un inverseur (11) recevant en entrée le signal de commande (C).

4. Interrupteur de puissance selon l'une quelconque des revendications précédentes, caractérisé en ce que le limiteur de tension comprend une diode Zener (8).
